# EUROPEAN PATENT APPLICATION

(11) **EP 2 571 061 A1**
(43) Date of publication of application: **20.03.2013**
(21) Application number: 11780475.7
(22) Date of filing: 19.04.2011
(51) Int. Cl.: H01L 31/042, B32B 27/18, B32B 27/30, B32B 27/32

(54) **BACKSIDE PROTECTIVE SHEET FOR SOLAR CELL AND SOLAR CELL MODULE COMPRISING SAME**

(30) Priority: 12.05.2010 JP 2010109857
(71) Applicant: Toyo Aluminium Kabushiki Kaisha, Osaka-shi, Osaka 541-0056 (JP)
(72) Inventor: MAEDA, Daisuke, Osaka-shi Osaka 541-0056 (JP); TERASAWA, Takanobu, Osaka-shi Osaka 541-0056 (JP)
(74) Representative: Grünecker, Kinkeldey, Stockmair & Schwanhäusser
(86) International application number: PCT/JP2011/059594
(87) International publication number: WO 2011/142218

(57) **Abstract**

Provided are a back side protective sheet for a solar cell capable of enhancing adherence to an EVA resin as a filler used to seal solar cell elements and of maintaining a weather resistance over a long period of time; and a solar cell module including the back side protective sheet for a solar cell. The back side protective sheet (10) for a solar cell, which is disposed on a back side of a solar cell module, includes: a first film (11) constituted of a laminated body formed by causing a linear low-density polyethylene layer (111), an interposing resin layer (113), and a linear low-density polyethylene layer (112) to directly contact each other in order; and a second film (12) laminated on the first film (11), with an adhesive layer (13) interposed between the first film (11) and the second film (12). The interposing resin layer (113) is formed of one kind of a resin selected from the group consisting of high-density polyethylene, polypropylene, a cycloolefin polymer, and a methacrylate resin.

## Description

### TECHNICAL FIELD

The present invention relates generally to a back side protective sheet for a solar cell disposed on a back side of a solar cell module and to a solar cell module including the back side protective sheet for a solar cell. More particularly, the present invention relates to a back side protective sheet for a solar cell, which has a long-term weather resistance, and to a solar cell module including the back side protective sheet for a solar cell.

### BACKGROUND ART

Because of the nature of a solar cell module, it is often the case that a solar cell module is installed outdoors. Therefore, in order to protect solar cell elements, electrodes, wires, and the like, for example, a transparent glass plate is disposed on a front side thereof and, for example, a laminated sheet of aluminum foil and a resin film, a laminated sheet of resin films, or the like is disposed on a back side thereof.

Japanese Patent Application Laid-Open Publication No. 2010-27714 (Patent Literature 1) has proposed a laminated sheet of aluminum foil and a resin film as a back side protective sheet for a solar cell which is excellent in a moisture proof property.

However, because in the back side protective sheet for a solar cell proposed in Japanese Patent Application Laid-Open Publication No. 2010-27714 (Patent Literature 1), an electrical short circuit between solar cell elements and the aluminum foil is likely to occur and corrosion of the aluminum foil is likely to be caused by a long-term use, a laminated sheet of resin films has been widely used as a back side protective sheet for a solar cell.

Solar cell elements are sealed by a filler of an ethylene-vinyl acetate copolymer (EVA) resin or the like and are disposed so as to be sandwiched between a transparent glass plate on the above-mentioned front side and a laminated sheet on a back side. Accordingly, the back side protective sheet for a solar cell is caused to adhere to an outer surface of the ethylene-vinyl acetate copolymer (EVA) resin by a hot-press. For example, Japanese Patent Application Laid-Open Publication No. 2008-211034 (Patent Literature 2) has proposed a back side protective sheet for a solar cell capable of enhancing adherence to the ERA resin as the filler used to seal the solar cell elements, of maintaining the weather resistance over a long period of time, and of reducing a weight. This back side protective sheet for a solar cell includes: a first film which contains linear low-density polyethylene having a density 0.91 g/cm³ or more and 0.93 g/cm³ or less; and a second film which contains polyvinylidene fluoride and polymethyl methacrylate and is laminated on the first film.

Along with the spread of solar power generation, a considerable long-term service life, which is a period of several decades, is expected of solar cells to be installed in a location having difficulties in installing the solar cells, such as a high place, in particular. However, the back side protective sheet for a solar cell proposed in Japanese Patent Application Laid-Open Publication No. 2008-211034 (Patent Literature 2) has a problem in that it is difficult to maintain a weather resistance over a long period of time of the several decades.

### CITATION LIST

### PATENT LITERATURE

Patent Literature 1: Japanese Patent Application Laid-Open Publication No. 2010-27714
Patent Literature 2: Japanese Patent Application Laid-Open Publication No. 2008-211034

### SUMMARY OF THE INVENTION

### TECHNICAL PROBLEM

Therefore, objects of the present invention are to provide a back side protective sheet for a solar cell capable of enhancing adherence to an EVA resin as a filler used to seal solar cell elements and of maintaining a weather resistance over a long period of time; and a solar cell module including the back side protective sheet for a solar cell.

### SOLUTION TO PROBLEM

A back side protective sheet for a solar cell according to the present invention, which is disposed on a back side of a solar cell module, includes: a first film constituted of a laminated body formed by causing linear low-density polyethylene, an interposing resin, and linear low-density polyethylene to directly contact each other in order; and a second film laminated on the first film, with an adhesive layer interposed between the first film and the second film. The interposing resin is one kind of a resin selected from the group consisting of high-density polyethylene, polypropylene, a cycloolefin polymer, and a methacrylate resin.

In the back side protective sheet for a solar cell according to the present invention, it is preferable that a density of the linear low-density polyethylene is 0.91 g/cm³ or more and 0.93 g/cm³ or less.

In the back side protective sheet for a solar cell according to the present invention, it is preferable that the adhesive layer is a urethane-based adhesive layer.

In the back side protective sheet for a solar cell according to the present invention, it is preferable that the linear low-density polyethylene includes 0.1% by mass or more and 30% by mass or less of an inorganic ultraviolet ray absorber having an average particle diameter of 0.1 µm or more and 5 µm or less.

In the back side protective sheet for a solar cell according to the present invention, it is preferable that the second film is formed of a fluorine-based resin.

A solar cell module according to the present invention includes: a filler formed of an ethylene-vinyl acetate copolymer resin disposed to seal solar cell elements; and the back side protective sheet for a solar cell, having any of the above-described features, fixedly attached on an outer surface of the filler on a back side of the solar cell module.

### ADVANTAGEOUS EFFECTS OF THE INVENTION

In a back side protective sheet for a solar cell according to the present invention, linear low-density polyethylene included in a first film is excellent in adherence to a filler formed of an ethylene-vinyl acetate copolymer resin disposed to seal solar cell elements and is capable of maintaining the adherence over time. In addition, as an interposing resin included in the first film, one kind of a resin selected from the group consisting of high-density polyethylene, polypropylene, a cycloolefin polymer, and a methacrylate resin is used, thereby enabling the prevention of deterioration of the first film caused by hydrolysis resulting from long-term moisture absorption and thermal action. The linear low-density polyethylene is excellent in adherence to the above-mentioned interposing resin.

Accordingly, according to the present invention, the adherence between an EVA resin as the filler used to seal the solar cell elements and the back side protective sheet can be enhanced and a weather resistance can be maintained over a long period of time.

### BRIEF DESCRIPTION OF THE DRAWINGS

Fig. 1 is a schematic diagram illustrating a cross section structure of a solar cell module to which a back side protective sheet for a solar cell, as one embodiment according to the present invention, is applied.
Fig. 2 shows a cross section view of the back side protective sheet for a solar cell, as the one embodiment according to the present invention.
Fig. 3 is a cross-section view illustrating one comparison form of a back side protective sheet for a solar cell.
Fig. 4 is a cross-section view illustrating another comparison form of a back side protective sheet for a solar cell.

### DESCRIPTION OF EMBODIMENTS

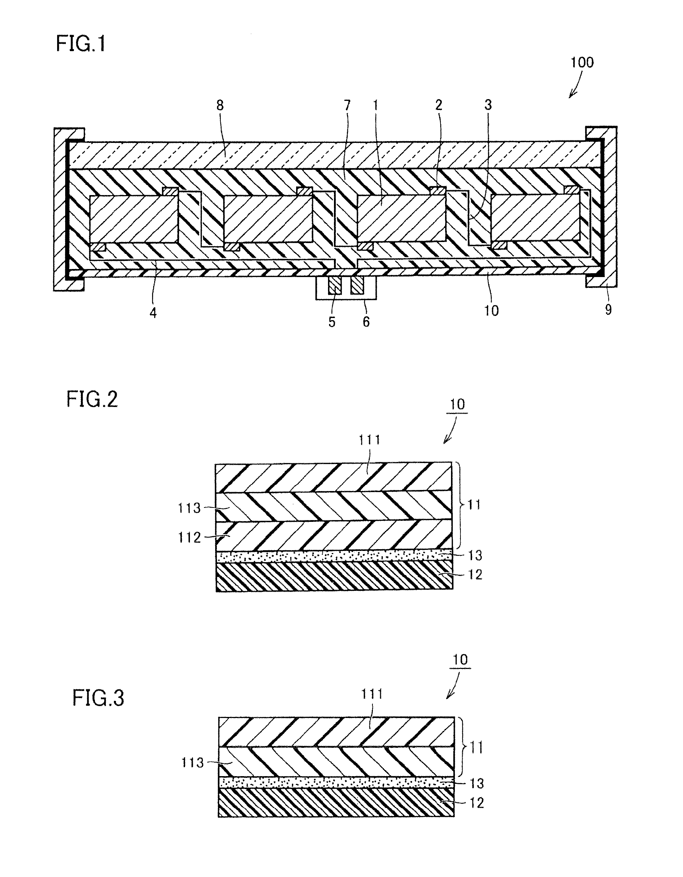

Fig. 1 is a schematic diagram illustrating a cross section structure of a solar cell module to which a back side protective sheet for a solar cell, as one embodiment according to the present invention, is applied.

As shown in Fig. 1, a multitude of solar cell elements 1 are arranged in the solar cell module 100. These solar cell elements 1 are electrically connected to each other via electrodes 2 by connection wires 3. In the whole solar cell module 100, terminals 5 are led out to a back side thereof by lead wires 4, and the terminals 5 are housed in a terminal box 6. A filler 7 constituted of an ethylene-vinyl acetate copolymer (EVA) resin is disposed to seal the multitude of solar cell elements 1. On an outer surface of the filler 7, which is located on a light receiving surface side of the solar cell module 100, a transparent glass layer 8 is fixedly attached. On an outer surface of the filler 7, which is located on an installation surface side of the solar cell module 100, the back side protective sheet 10 for a solar cell is fixedly attached. On side surfaces of the solar cell module 100, a frame member 9 formed of aluminum is attached via a sealant.

Fig. 2 shows a cross section view of the back side protective sheet for a solar cell, as the one embodiment according to the present invention.

As shown in Fig. 2, in the back side protective sheet 10 for a solar cell, a first film 11 and a second film 12 are laminated in order from an inner layer disposed on a side (inner side) relatively close to the solar cell module 100. Between the first film 11 and the second film 12, a urethane adhesive layer 13 is disposed. The first film 11 is fixedly attached so as to abut a surface of the filler 7. This attachment is conducted by using a hot-press. The second film 12 is disposed in an outermost layer of the back side protective sheet 10 for a solar cell. The first film 11 includes: linear low-density polyethylene layers 111 and 112 and an interposing resin layer 113 sandwiched between the linear low-density polyethylene layers 111 and 112. In other words, in the first film 11, the linear low-density polyethylene layer 111, the interposing resin layer 113, and the linear low-density polyethylene layer 112 are formed so as to directly contact each other in order. The interposing resin layer 113 is formed of one kind of a resin selected from the group consisting of high-density polyethylene, polypropylene, a cycloolefin polymer, and a methacrylate resin.

(First Film)

The linear low-density polyethylene layer 111 serves to enhance adherence between a sealant such as the EVA resin and the interposing resin layer 113. The linear low-density polyethylene layer 112 serves to enhance adherence with the interposing resin layer 113. It is preferable that a density of the linear low-density polyethylene is 0.91 g/cm³ or more and 0.93 g/cm³ or less.

The one kind of a resin selected from the group consisting of the high-density polyethylene (PE), the polypropylene (PP), the cycloolefin polymer (CPE), and the methacrylate resin (PMMA) is used as the interposing resin layer 113, thereby enabling the prevention of deterioration of the first film 11 caused by hydrolysis resulting from long-term moisture absorption and thermal action. Each of these resins is an olefin resin, which is referred to as a non-polar olefin resin or a low-polarity olefin resin and has no functional groups having a polar character or does not have many reactive functional groups, has a property hardly causing the hydrolysis due to a low moisture absorption property thereof. In particular, since the cycloolefin polymer is a hydrocarbon-based polymer having an alicyclic structure as a ring-opening polymer of the cycloolefin, the cycloolefin polymer constantly has a non-polar structure.

In contrast to this, as an olefin resin having a high polar character (in other words, which is not the non-polar olefin resin or not the low-polarity olefin resin), polyester such as polyethylene terephthalate can be cited. The resin having the high polar character easily reacts with a solvent having a polar character, that is, water. Therefore, for example, the polyethylene terephthalate which is one example of the resin having the polar character reacts with the water and generates terephthalic acid. Because the generation of this terephthalic acid exerts an influence on a molecular structure of the polyethylene terephthalate, a mechanical strength, a moisture proof property, and the like of film are reduced.

The non-polar or low-polarity olefin resin of which the interposing resin layer 113 is formed is inferior in adhesiveness with an adhesive, having the polar character, such as a polyurethane-based adhesive widely used as a dry laminating adhesive in particular, as compared with a resin having the high polar character such as the polyethylene terephthalate. Therefore, in the first film 11, the linear low-density polyethylene layer 111, the interposing resin layer 113, and the linear low-density polyethylene layer 112 are formed so as to directly contact each other in order without interposing an adhesive layer. The linear low-density polyethylene is an olefin resin having a multipolar character and exhibits favorable adhesiveness with any of a non-polar olefin-based resin, a polyurethane-based adhesive, or the EVA.

A method for configuring the first film 11 may be a method in which the interposing resin layer 113 is formed to be film and concurrently therewith, the linear low-density polyethylene layers 111 and 112 are formed on both sides of the formed film. Specifically, by employing a co-extrusion method in which a T-die film formation method or an inflation film formation method is adopted, a coating method, or the like, the linear low-density polyethylene layer 111, the interposing resin layer 113, and the linear low-density polyethylene layer 112 may be concurrently caused to adhere closely to each other, thereby forming the first film 11. In particular, since when the co-extrusion method is employed, it is easy to control a thickness of each of the resin layers, a laminated film having a large width can be stably obtained.

It is only required that a thickness of the interposing resin layer 113 is 20 µm or more and 200 µm or less. It is preferable that the thickness thereof is 50 µm or more and 150 µm or less, and it is more preferable that the thickness thereof is 80 µm or more and 150 µm or less. If the thickness of the interposing resin layer 113 is less than 20 um, an effect of a moisture proof property, attained by the interposing resin layer 113, is not sufficient. If the thickness of the interposing resin layer 113 exceeds 200 µm, the effect of the moisture proof property, attained by the interposing resin layer 113, becomes saturated. A coloring agent may be added to the interposing resin layer 113, thereby configuring a colored film.

Each of the linear low-density polyethylene layers 111 and 112 may include 0.1% by mass or more and 30% by mass or less of an inorganic ultraviolet ray absorber having an average particle diameter of 0.1 µm or more and 5 µm or less. As the inorganic ultraviolet ray absorber contained in each of the linear low-density polyethylene layers 111 and 112, titanium oxide, zinc oxide, zirconium oxide, calcium carbonate, cerium oxide, aluminum oxide, silica, iron oxide, carbon, and the like are cited, and the titanium oxide or the carbon is preferably used. If the average particle diameter of the ultraviolet ray absorber exceeds 5 µm, dispersibility in each of the linear low-density polyethylene layers 111 and 112 is worsened, whereby it is likely that an effect of uniform ultraviolet ray absorption cannot be obtained. In addition, if the average particle diameter of the ultraviolet ray absorber is less than 0.1 µm, a price per unit weight is increased. If the content of the inorganic ultraviolet ray absorber is less than 0.1% by mass, the effect of the ultraviolet ray absorption is not sufficient, and it is likely that the back side protective sheet 10 for a solar cell is yellowed. In addition, if the content of the inorganic ultraviolet ray absorber exceeds 30% by mass, it is likely that adherence thereof with the sealant, the adhesive layer, and the interposing resin layer is reduced.

It is only required that a thickness of the linear low-density polyethylene layer 111 is 30 µm or more and 150 µm or less, and it is preferable that the thickness thereof is 30 µm or more and 80 µm or less. It is only required that a thickness of the linear low-density polyethylene layer 112 is 10 µm or more and 150 µm or less, and it is preferable that the thickness thereof is 20 µm or more and 80 µm or less. If the thickness of the linear low-density polyethylene layer 111 is less than 30 µm or the thickness of the linear low-density polyethylene layer 112 is less than 10 µm, it is likely that adherence thereof with the sealant or the adhesive layer is reduced. In addition, in a case where each of the linear low-density polyethylene layers 111 and 112 includes the ultraviolet ray absorber, if the thickness of the linear low-density polyethylene layer 111 is less than 30 µm or the thickness of the linear low-density polyethylene layer 112 is less than 10 µm, an effect of the ultraviolet ray absorption, attained by the ultraviolet ray absorber, is not sufficient, and it is likely that a part of transmitted ultraviolet rays promotes deterioration of the back side protective sheet 10 for a solar cell. If the thickness of each of the linear low-density polyethylene layers 111 and 112 exceeds 150 µm, the adherence thereof with the sealant or the adhesive layer and the effect of the ultraviolet ray absorption become saturated. A coloring agent is added to each of the linear low-density polyethylene layers 111 and 112, thereby configuring colored films.

(Second Film)

A weather resistance and an electrical insulating property are required of the second film 12. A polyester film such as polyethylene naphthalate (PEN) and polyethylene terephthalate (PET); a fluorine-based film such as polyvinylidene fluoride (PVDF), polyvinyl fluoride (PVF), and ethylene-tetrafluoroethylene (ETFE); a polyolefin film such as polyethylene and polypropylene; a polystyrene film; a polyamide film; a polyvinyl chloride film; a polycarbonate film; a polyacrylonitrile film; a polyimide film; or the like can be used. In addition, a laminated film may constitute the second film 12, instead of a single-layer film.

In a case where the laminated film constitutes the second film 12, it is preferable that a film excellent in the weather resistance and a film excellent in the electrical insulating property are laminated. In this case, the film excellent in the electrical insulating property is laminated on a side of the first film 11. As the film excellent in the weather resistance, it is preferable that the fluorine-based film, in particular, whose thickness is 20 µm or more and 150 µm or less is used. As the film excellent in the electrical insulating property, the polyethylene terephthalate (PET), in particular, whose thickness is 100 µm or more and 250 µm or less is preferably used.

(Adhesive Layer)

The first film 11 and the second film 12 are laminated by using an urethane adhesive and employing a dry lamination method. As the urethane adhesive, although there are a two-part curable urethane adhesive, a polyether urethane adhesive, a polyester polyurethane polyol adhesive, and the like, in particular, it is preferable that the two-part curable urethane adhesive is used.

The first film 11 and the second film 12 can be laminated by employing the heretofore known method. For example, as described above, a method in which the first film 11 and the second film 12 are laminated with the adhesive layer 13 interposed therebetween as shown in Fig. 2 by using the urethane adhesive and employing the dry lamination method is employed. In addition to the above-mentioned method, a co-extrusion method, an extrusion coat method, a thermal lamination method using an anchor coat agent, or the like may be adopted to laminate the first film 11 and the second film 12.

### EXAMPLES

Test samples of examples, comparison examples, and a reference example of the back side protective sheet for a solar cell were prepared as described below.

(Example 1)

To 100 parts by mass of a polyethylene resin (ULTZEX manufactured by Mitsui Chemicals, Inc.) having a density of 0.93 g/cm³, 4.5 parts by mass of titanium oxide particles having an average particle diameter of 0.3 µm were added and the resultant was sufficiently kneaded, thereby preparing a linear low-density polyethylene composition. With an interposing resin sandwiched between these linear low-density polyethylene compositions, film formation was conducted by means of a T-die extruder by employing a co-extrusion method, and as shown in Fig. 2, a first film 11 was prepared such that thicknesses of a linear low-density polyethylene layer 111, an interposing resin layer 113, and a linear low-density polyethylene layer 112 were 50 µm, 100 µm, and 50 µm, respectively. As the interposing resin layer 113, a high-density polyethylene (Novatec HD manufactured by Japan Polyethylene Corporation) was used.

Next, polyvinyl fluoride (PVF) (Tedlar manufactured by DuPont Co., Ltd.) having a thickness of 38 µm was used as a second film 12. The above-mentioned first film 11 and second film 12 were bonded by using a dry laminating adhesive and employing a dry lamination method, thereby preparing a back side protective sheet 10 for a solar cell. As an adhesive layer 13, a polyurethane-based adhesive obtained by mixing 100 parts by mass of "product name: TAKELAC A315" and 10 parts by mass of "product name: TAKENATE A50", both of which were manufactured by Mitsui Chemicals Polyurethanes Co., Ltd., was prepared with a solid content coated amount of 5 g/m².

(Example 2)

As an interposing resin layer 113, polypropylene (Novatec PP manufactured by Japan Polypropylene Corporation) was used. In addition, as a second film 12, polyvinylidene fluoride (PVDF) (manufactured by DENKI KAGAKU KOGYO KABUSHIKI KAISHA) having a thickness of 40 µm was used. The other configuration was made the same as that of example 1, thereby preparing a back side protective sheet 10 for a solar cell.

(Example 3)

As an interposing resin layer 113, cycloolefin polymer (ZEONOR manufactured by ZEON CORPORATION) was used. In addition, as a second film 12, polyvinylidene fluoride (PVDF) (manufactured by DENKI KAGAKU KOGYO KABUSHIKI KAISHA) having a thickness of 40 µm was used. The other configuration was made the same as that of example 1, thereby preparing a back side protective sheet 10 for a solar cell.

(Example 4)

As an interposing resin layer 113, a methacrylate resin (SUMIPEX manufactured by Sumitomo Chemical Company, Limited) was used. The other configuration was made the same as that of example 1, thereby preparing a back side protective sheet 10 for a solar cell.

(Comparison Example 1)

Film formation was conducted by means of the T-die extruder used in example 1 by employing a co-extrusion method, and as shown in Fig. 3, a first film 11 was prepared such that thicknesses of a linear low-density polyethylene layer 111 and an interposing resin layer 113 were 100 µm and 100 µm, respectively. As an interposing resin layer 113, cycloolefin polymer (ZEONOR manufactured by ZEON CORPORATION) was used. Next, polyvinyl fluoride (PVF) (Tedlar manufactured by DuPont Co., Ltd.) having a thickness of 38 µm was used as a second film 12. A side of the first film 11 on a side of the interposing resin layer 113 and the second film 12 were bonded by using a dry laminating adhesive and employing a dry lamination method in the same manner as in example 1, thereby preparing a back side protective sheet 10 for a solar cell.

(Comparison Example 2)

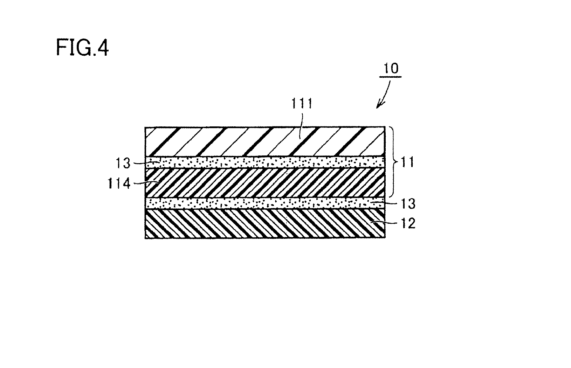

To 100 parts by mass of a polyethylene resin (ULTZEX manufactured by Mitsui Chemicals, Inc.) having a density of 0.93 g/cm³, 4.5 parts by mass of titanium oxide particles having an average particle diameter of 0.3 µm were added and the resultant was sufficiently kneaded, thereby preparing a linear low-density polyethylene composition. Film formation of this linear low-density polyethylene composition was conducted by means of a T-die extruder, thereby forming film which a linear low-density polyethylene layer 111 having a thickness of 50 µm constitutes. As shown in Fig. 4, the film constituted of the linear low-density polyethylene layer 111 and a PET film (manufactured by TOYOBO CO., LTD.) 114 having a thickness of 125 µm were bonded by using a dry laminating adhesive and employing a dry lamination method, thereby preparing a first film 11. As a adhesive layer 13, a polyurethane-based adhesive obtained by mixing 100 parts by mass of "product name: TAKELAC A315" and 10 parts by mass of "product name: TAKENATE A50", both of which were manufactured by Mitsui Chemicals Polyurethanes Co., Ltd., was prepared with a solid content coated amount of 5 g/m².

Next, a side of the first film 11 on a side of the PET film 114 and the second film 12 were bonded by using a dry laminating adhesive and employing a dry lamination method in the same manner as in example 1, thereby preparing a back side protective sheet 10 for a solar cell.

(Reference Example)

To 100 parts by mass of a polyethylene resin (ULTZEX manufactured by Mitsui Chemicals, Inc.) having a density of 0.93 g/cm³, 4.5 parts by mass of titanium oxide particles having an average particle diameter of 0.3 µm were added and the resultant was sufficiently kneaded, thereby preparing a linear low-density polyethylene composition. Film formation of this linear low-density polyethylene composition was conducted by means of a T-die extruder, thereby forming a back side protective sheet for a solar cell, which only a linear low-density polyethylene film having a thickness of 200 µm constitutes.

A weather resistance of each of the back side protective sheets 10 for solar cells prepared as described above was evaluated as follows.

(Weather Resistance I)

With respect to the back side protective sheet 10 for a solar cell in each of examples 1 through 4 and comparison examples 1 through 2, a peel strength between the first film 11 and the second film 12 was measured in conformity with a T-type peel test of JIS K6854 at a peel rate of 100 mm/minute. Here, a width of a test specimen was 15 mm. From a value (A) of a peel strength measured immediately after the preparation of each test specimen and a value (B) of a peel strength measured after each test specimen had been retained under conditions of a pressure cooker test (a temperature of 120°C, a relative humidity of 100%, and a pressure of 2 atmospheres) for 100 hours, a peel strength retention [%] was calculated by using the following equation.

Peel strength retention [%] = {(B - A)/A} × 100

These percentages of the peel strength retention were evaluated as Weather Resistance I.

(Weather Resistance II)

With respect to the first film 11 in the back side protective sheet 10 for a solar cell in each of examples 1 through 4 and the back side protective sheet for a solar cell in reference example (the linear low-density polyethylene film alone), a moisture proof property (water vapor permeability) was measured in conformity with a humidity sensor method of JIS K7129: 2008 by means of a L80-5000 model manufactured by PBI-Dansensor.

(Weather Resistance III)

A moisture proof property (water vapor permeability) of the whole of each of the back side protective sheets 10 for solar cells was measured as in the same manner as in the measurement of the above-mentioned weather resistance II. From a value (C) of a water vapor permeability measured immediately after the preparation of each test specimen and a value (D) of a water vapor permeability measured after each test specimen had been retained under conditions of a pressure cooker test (a temperature of 120°C, a relative humidity of 100%, and a pressure of 2 atmospheres) for 100 hours, each water vapor permeability change rate [%] was calculated by using the following equation.

Water vapor permeability change rate [%] = {1 - (D/C)} × 100

These water vapor permeability change rates were evaluated as Weather Resistance III. The values of the water vapor permeability change rates which are positive indicate that the water vapor permeabilities were decreased after the pressure cooker test, and the values of the water vapor permeability change rates which are negative indicate that the water vapor permeabilities were increased after the pressure cooker test.

The results described above are shown in Table 1.

**[Table 1]**

| | Weather Resistance I [%] | Weather Resistance II [g/m²-24 hours] | Weather Resistance III [%] |
|---|---|---|---|
| Example 1 | -2.8 | 1.5 | +6.3 |
| Example 2 | -2.0 | 1.2 | +1.4 |
| Example 3 | -2.8 | 0.8 | +5.0 |
| Example 4 | -3.8 | 1.5 | -5.0 |
| Comparison Example 1 | -58.6 | - | -6.3 |
| Comparison Example 2 | -84.3 | - | -43.0 |
| Reference Example | - | 3.6 | - |

It is seen from the results shown in Table 1 that in the back side protective sheet 10 for a solar cell in each of examples 1 through 4 according to the present invention, even after the accelerated life test for the moisture resistance evaluation, the peel strengths of the first and second films are favorably maintained and the moisture proof property is also favorably maintained, as compared with the back side protective sheet 10 for a solar cell in each of comparison examples 1 through 2. Accordingly, it is seen that the back side protective sheet 10 for a solar cell in each of examples 1 through 4 according to the present invention can maintain a weather resistance over a long period of time, as compared with the back side protective sheet 10 for a solar cell in each of comparison examples 1 through 2.

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

### INDUSTRIAL APPLICABILITY

A back side protective sheet for a solar cell according to the present invention is disposed on a back side of a solar cell module to be used, is capable of enhancing adherence between an EVA resin as filler used to seal solar cell elements and the back side protective sheet, and allows a weather resistance to be maintained over a long period of time.

### REFERENCE SIGNS LIST

10: back side protective sheet for a solar cell, 11: first film, 12: second film, 13: adhesive layer, 100: solar cell module, 111, 112: linear low-density polyethylene, 113: interposing resin layer.

## Claims

1. A back side protective sheet (10) for a solar cell disposed on a back side of a solar cell module, comprising:
a first film (11) constituted of a laminated body formed by causing linear low-density polyethylene (111), an interposing resin (113), and linear low-density polyethylene (112) to directly contact each other in order; and
a second film (12) laminated on the first film (11), with an adhesive layer (13) interposed between the first film (11) and the second film (12),
the interposing resin (113) being one kind of a resin selected from the group consisting of high-density polyethylene, polypropylene, a cycloolefin polymer, and a methacrylate resin.

2. The back side protective sheet (10) for a solar cell according to claim 1, wherein a density of the linear low-density polyethylene is 0.91 g/cm³ or more and 0.93 g/cm³ or less.

3. The back side protective sheet (10) for a solar cell according to claim 1, wherein the adhesive layer (13) is a urethane-based adhesive layer.

4. The back side protective sheet (10) for a solar cell according to claim 1, wherein the linear low-density polyethylene includes 0.1% by mass or more and 30% by mass or less of an inorganic ultraviolet ray absorber having an average particle diameter of 0.1 µm or more and 5 µm or less.

5. The back side protective sheet (10) for a solar cell according to claim 1, wherein the second film (12) is formed of a fluorine-based resin.

6. A solar cell module (100) comprising:
a filler (7) formed of an ethylene-vinyl acetate copolymer resin disposed to seal solar cell elements (1); and
the back side protective sheet (10) for a solar cell according to claim 1, fixedly attached on an outer surface of the filler (7) on a back side of the solar cell module (100).
